# EUROPÄISCHE PATENTANMELDUNG

(11) **EP 1 918 993 A1**
(43) Veröffentlichungstag der Anmeldung: **07.05.2008**
(21) Anmeldenummer: 07020669.3
(22) Anmeldetag: 23.10.2007
(51) Int. Cl.: H01L 27/142, H01L 31/0224, B23K 26/03, B28D 5/00

(54) **Verfahren zum Strukturieren von Solarmodulen und Strukturierungsvorrichtung**

(30) Priorität: 02.11.2006 DE 102006051556
(71) Anmelder: Manz Automation AG, 72768 Reutlingen (DE)
(72) Erfinder: Manz, Dieter, 72667 Schlaitdorf (DE)
(74) Vertreter: Kohler Schmid Möbus

(57) **Zusammenfassung**

Bei einem Verfahren zum Strukturieren von Solarmodulen (12), bei dem mittels eines Strukturierungswerkzeugs (14) eine Spur in ein Solarmodul (12) eingebracht wird, wird die eingebrachte Spur zeitgleich von einem dem Strukturierungswerkzeug (14) nachlaufenden Sensor (16) erfasst. Dadurch ist eine Qualitätskontrolle möglich.

## Beschreibung

Die Erfindung betrifft ein Verfahren zum Strukturieren von Solarmodulen, bei dem mittels eines Strukturierungswerkzeugs eine Spur in ein Solarmodul eingebracht wird, sowie eine Strukturierungsvorrichtung.

Zur Herstellung von Dünnschichtsolarmodulen werden Glassubstrate eingesetzt, welche in Beschichtungsanlagen in der Regel mit drei Schichten beschichtet werden. Zur Serienverschaltung der einzelnen Zellen innerhalb eines Solarmoduls werden die Schichten in drei Strukturierungsschritten selektiv aufgetrennt, indem Linien (Spuren) in die Solarmodule eingebracht werden.

Bei einer zu großen Spurbreite leidet die Effizienz des Solarmoduls. Außerdem kann es zu Kurzschlüssen zwischen den Spuren kommen.

Aufgabe der vorliegenden Erfindung ist es, ein Verfahren und eine Vorrichtung bereitzustellen, mit denen die Qualität einer eingebrachten Spur überwacht werden kann.

Gelöst wird diese Aufgabe auf überraschende und einfache Art und Weise durch ein Verfahren der eingangs genannten Art, bei dem die eingebrachte Spur von einem nachlaufenden Sensor erfasst wird. Durch diese Maßnahme können Korrekturen an dem Strukturierungswerkzeug unmittelbar vorgenommen werden, sodass die Qualität der Spur für die restliche einzubringende Spur im laufenden Prozess verbessert werden kann. Daher ist es besonders vorteilhaft, wenn der Sensor in geringem Abstand hinter dem Strukturierungswerkzeug bzw. zeitgleich mit dem Strukturierungswerkzeug entlang des Solarmoduls bewegt wird.

Bei einer besonders bevorzugten Verfahrensvariante kann vorgesehen sein, dass die Breite und/oder Tiefe der Spur erfasst wird. Die Effizienz eines Solarmoduls kann verbessert werden, wenn für die Spuren möglichst wenig Platz benötigt wird. Dies ist zum einen dann möglich, wenn die Spuren dicht beieinander liegen und zum anderen, wenn die Spurbreite gering ist. Durch das erfindungsgemäße Verfahren kann sichergestellt werden, dass möglichst schmale Spuren während der Strukturierung eingebracht werden. Durch das Erfassen und die Kontrolle der Spurtiefe kann verhindert werden, dass von einer Spur zu einer anderen Spur in einer anderen (tiefer liegenden) Schicht durchkontaktiert wird und ein Kurzschluss entsteht.

Die Erfassung der Spur erfolgt vorzugsweise optisch. Beispielsweise kann das Solarmodul mit einer oder mehreren Lichtquellen, insbesondere Lasern oder LEDs bestrahlt werden. Ein oder mehrere von dem Solarmodul reflektierte Signale und/oder ein oder mehrere Transmissionssignale können erfasst und ausgewertet werden. Beispielsweise ist es denkbar, dass unterschiedliche Wellenlängen erfasst und die entsprechenden Informationen ausgewertet werden. Beispielsweise können zwei Messpunkte aufgenommen werden - jeweils ein Messpunkt an einer Kante der zu erfassenden Spur. Alternativ können drei Messpunkte aufgenommen werden, wobei zumindest ein Messpunkt innerhalb der zu erfassenden Spur liegen sollte. Als Detektoren können beispielsweise ein- oder mehrdimensionale Arrays oder Sensoren, insbesondere CCD-Chips verwendet werden.

Weiterhin ist es denkbar, eine konvokale Abbildung zu erzeugen und aus dieser Abbildung Tiefeninformationen der gerade eingebrachten Spur zu ermitteln. Aufgrund dieser Tiefeninformation kann das Strukturierungswerkzeug geregelt werden.

Besonders bevorzugt ist eine Verfahrensvariante, bei der die Bestimmung des Verlaufs der eingebrachten Spur optisch erfolgt. Dabei können sowohl Reflektions- als auch Transmissionseigenschaften des Substrats und der bereits aufgebrachten dünnen Schichten genutzt werden. Die optische Messung kann sowohl von der Unterseite des Substrats als auch von der beschichteten Oberseite des Substrats erfolgen. Die optische Bestimmung ist besonders kostengünstig.

Alternativ oder zusätzlich können die Positionen einer vorher eingebrachten und der aktuell eingebrachten Spur erfasst werden. Dabei können die Absolutpositionen oder eine relative Lage der Spuren zueinander erfasst werden. Dadurch kann der Abstand der Spuren vermessen und eingestellt bzw. gegebenenfalls für den weiteren Prozess korrigiert werden.

Besonders bevorzugt ist es, wenn zumindest eine die Qualität der Spur beschreibende Größe ermittelt oder erfasst wird und diese Größe mit einer Referenzgröße verglichen wird, wobei bei einem vorgegebenen Vergleichsergebnis eine Qualitätsverbesserungsmaßnahme eingeleitet wird. Als die Qualität der Spur beschreibende Größen kommen beispielsweise die Spurbreite, die Spurtiefe oder der Spurabstand in Betracht. Wenn als Vergleichsergebnis eine eine vorgegebene Breite überschreitende Spurbreite (zu große Spurbreite) oder eine eine vorgegebene Tiefe überschreitende Spurtiefe (zu große Spurtiefe) festgestellt wird, kann korrigierend auf das Strukturierungswerkzeug eingewirkt werden. Es kann also überwacht werden, ob sich die eingebrachte Spur innerhalb vorgegebener Toleranzen bewegt. Dazu können auch zwei Referenzgrößen, eine obere und eine untere Grenze, vorgegeben werden, deren Einhaltung überwacht wird. Außerdem kann überwacht und darauf hingewirkt werden, dass die Spuren einen Mindestabstand aufweisen. Als Qualitätssicherungsmaßnahmen können also die für die Breite, Tiefe oder Position maßgeblichen Prozessparameter variiert werden.

Weitere Vorteile ergeben sich, wenn die Solarmodulstrukturierung mittels Laser erfolgt und die Laserleistung und/oder die Fokuslage und/oder das Strahlprofil des Lasers in Abhängigkeit von der erfassten Spurbreite und/oder Spurtiefe eingestellt wird. Durch diese Maßnahme kann eine Regelung bzw. Steuerung des als Strukturierungswerkzeug verwendeten Lasers erfolgen, insbesondere dergestalt, dass eine optimale Breite und Tiefe der Spur erreicht wird.

Weiterhin kann vorgesehen sein, dass die Solarmodulstrukturierung mittels eines mechanischen Strukturierungswerkzeugs, insbesondere eines Stichels, erfolgt und der Anpressdruck des mechanischen Strukturierungswerkzeugs an das Solarmodul in Abhängigkeit von der erfassten Spurbreite und/oder Spurtiefe eingestellt wird. Durch diese Maßnahme können die erzeugte Spurtiefe und Spurbreite eingestellt bzw. korrigiert werden. Außerdem kann auf unterschiedliche Schichtdicken reagiert werden. Beispielsweise kann durch diese Maßnahmen vermieden werden, dass eine dünne Schicht im Bereich der Spur vollständig entfernt wird. An dieser Stelle ist darauf hinzuweisen, dass bei Solarmodulen üblicherweise in drei Schichten Spuren erzeugt werden. In unterschiedlichen Schichten können die Spuren mit unterschiedlichen Strukturierungswerkzeugen eingebracht werden, wobei die Spuren in jeder Schicht mit einem nachlaufenden Sensor überwacht werden können.

Alternativ oder zusätzlich kann vorgesehen sein, dass die Solarmodulstrukturierung mittels eines mechanischen Strukturierungswerkzeugs, insbesondere eines Stichels, erfolgt und ein Nachschärfen des mechanischen Werkzeugs in Abhängigkeit von der erfassten Spurbreite und/oder Spurtiefe durchgeführt wird. Durch die Erfassung der erzeugten Spur mittels eines Sensors kann erkannt werden, wenn das mechanische Strukturierungswerkzeug stumpf ist. Der Strukturierungsvorgang kann dann unterbrochen werden, um das mechanische Werkzeug nachschärfen zu können oder die Spur kann zu Ende strukturiert werden und das Strukturierungswerkzeug kann nachgeschärft werden, ehe es erneut zum Einbringen einer Spur verwendet wird.

Bei einer bevorzugten Verfahrensvariante kann vorgesehen sein, dass aufgrund der Sensorsignale auf einen Bruch des Solarmoduls oder einen Kurzschluss zwischen Spuren geschlossen wird. Ein solches beschädigtes Solarmodul ist Ausschuss und kann dann unmittelbar entfernt werden, ehe weitere Zeit und Kosten aufgewendet werden, um das Solarmodul fertigzustellen.

In den Rahmen der Erfindung fällt außerdem eine Strukturierungsvorrichtung zur Strukturierung von Solarmodulen, mit einem Strukturierungswerkzeug, wobei ein dem Strukturierungswerkzeug nachlaufender, die mittels des Strukturierungswerkzeugs eingebrachte Spur erfassender Sensor vorgesehen ist. Mit einem solchen Sensor kann zeitnah eine Qualitätskontrolle der eingebrachten Spur erfolgen. Bei erkannter fehlerhafter Spur oder beim Erkennen einer Spur mit schlechter Qualität oder zu geringem bzw. zu großem Abstand zu einer vorher eingebrachten Spur kann unmittelbar reagiert werden.

In diesem Zusammenhang ist es besonders vorteilhaft, wenn eine mit dem Sensor datentechnisch in Verbindung stehende Auswerteeinrichtung zur Verarbeitung der Sensorsignale vorgesehen ist. In der Auswerteeinrichtung können die Sensorsignale ausgewertet werden und kann insbesondere eine Bewertung dahingehend vorgenommen werden, ob sich die erzeugte Spur im Rahmen zulässiger Toleranzen bewegt. Ist dies nicht der Fall, so können durch die Auswerteeinrichtung, die als Steuerung ausgebildet sein kann, entsprechende Maßnahmen eingeleitet werden.

Die Auswerteeinrichtung kann insbesondere so ausgebildet sein, dass die Sensorsignale direkt analog ausgewertet werden. Die analogen Signale können unmittelbar einer Steuerung des Strukturierungswerkzeugs, beispielsweise einem Laser, zugeführt werden. Weiterhin ist es möglich, die analogen Signale einer Hardware zuzuführen und dann mittels einer Software weiterzuverarbeiten. Aufgrund der erfassten Signale kann beispielsweise festgestellt werden, ob das Substrat gewellt ist und ob eine Nachfokussierung notwendig ist. Diese kann gegebenenfalls durchgeführt werden.

Wenn das Strukturierungswerkzeug ein Laser ist, kann eine besonders schnelle Regelung erfolgen, indem als Sensorsignale beispielsweise die Intensität gemessen wird und ein korrespondierendes Analogsignal direkt auf die Steuerung des Lasers gegeben wird. Das Analogsignal kann gegebenenfalls vorher aufbereitet werden.

Der oder die Sensoren arbeiten vorzugsweise nicht scannend. Dies bedeutet, dass vorzugsweise kein Abtasten in Spurquerrichtung erfolgt. Es erfolgt allenfalls eine Nachführung quer zur Spurquerrichtung als Ergebnis einer Regelung. Um einen Startpunkt zu finden ist es gegebenenfalls notwendig, am Anfang der Spurerfassung einen initialen Scannvorgang quer zur Strukturierungsrichtung durchzuführen.

Bei einer Weiterbildung kann eine Einstelleinrichtung zur Einstellung des Strukturierungswerkzeugs vorgesehen sein, die durch die Auswerteeinrichtung angesteuert ist. Die Einstelleinrichtung kann dabei beispielsweise ein Antrieb zur Höhenverstellung eines mechanischen Strukturierungswerkzeugs sein. Alternativ ist es denkbar, dass die Einstelleinrichtung eine Leistungsversorgung eines Lasers oder eine verstellbare Fokussieroptik für einen Laser ist, wenn das Strukturierungswerkzeug ein Laser ist.

Bei einer besonders bevorzugten Ausgestaltung der Erfindung kann vorgesehen sein, dass der Sensor als optischer Sensor oder als mechanischer Sensor ausgebildet ist. Der Vorteil eines optischen Sensors, beispielsweise einer Kamera mit nachgeschalteter Bildverarbeitung, liegt darin, dass die eingebrachte Spur berührungslos erfasst werden kann. Spuren werden in unterschiedlichen Schichten eingebracht. Dabei ist es denkbar, dass unterschiedliche Sensoren für die unterschiedlichen Schichten vorgesehen sind. Außerdem können an einem Solarmodul manche Spuren mittels eines Lasers und andere Spuren mittels eines mechanischen Strukturierungswerkzeugs, wie z. B. einem Stichel, eingebracht werden. Für auf unterschiedliche Art und Weise eingebrachte Spuren können unterschiedliche Sensoren vorgesehen sein.

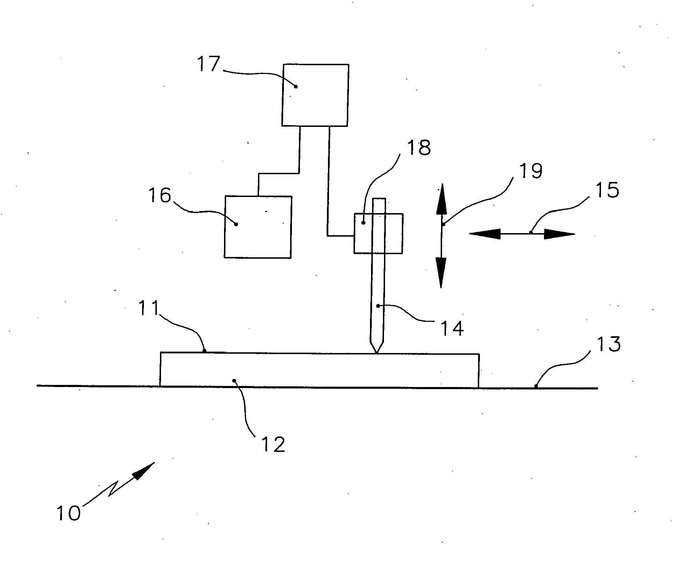

Weitere Merkmale und Vorteile der Erfindung ergeben sich aus der nachfolgenden Beschreibung von Ausführungsbeispielen der Erfindung, anhand der Figur der Zeichnung, die erfindungswesentliche Einzelheiten zeigt, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu der Figur der Zeichnung näher erläutert.

Die einzige Figur zeigt stark schematisiert eine Strukturierungsvorrichtung 10. In die Oberfläche 11 eines Solarmoduls 12, das auf einer Auflage 13 aufliegt, wird mittels eines Strukturierungswerkzeugs 14, welches im Ausführungsbeispiel als mechanisches Strukturierungswerkzeug, insbesondere als Stichel, ausgebildet ist, eine Spur eingebracht bzw. eingeritzt. Dies geschieht, indem das Strukturierungswerkzeug 14 beispielsweise in Doppelpfeilrichtung 15 mit einem definierten Anpressdruck entlang dem Solarmodul 12 verfahren wird. Gemeinsam mit dem Strukturierungswerkzeug 14 wird ein Sensor 16 Verfahren, der die durch das Strukturierungswerkzeug 14 eingebrachte Spur erfasst. Vorzugsweise sind der Sensor 16 und das Strukturierungswerkzeug 14 mechanisch gekoppelt, sodass diese gemeinsam bewegt werden. Es ist jedoch auch denkbar, dass der Sensor 16 unabhängig vom Strukturierungswerkzeug 14 bewegt wird.

Der Sensor 16 steht datentechnisch mit einer Auswerteeinrichtung 17 in Verbindung, die die Qualität der erfassten Spurbreite bewertet. In Abhängigkeit von dieser Bewertung kann eine als Antrieb ausgebildete Einstelleinrichtung 18 angesteuert werden, mit der das Strukturierungswerkzeug 14 in Doppelpfeilrichtung 19 bewegt werden kann, um den Anpressdruck und damit die Spurtiefe und Spurbreite zu variieren. Es können außerdem weitere Antriebe vorgesehen sein, die zur Bewegung des Strukturierungswerkzeugs 14 in Doppelpfeilrichtung 15 oder schräg dazu benötigt werden. Auch diese Antriebe können durch die Auswerteeinrichtung 17 oder eine Steuerung, deren Bestandteil die Auswerteeinrichtung 17 sein kann, angesteuert werden.

## Patentansprüche

1. Verfahren zum Strukturieren von Solarmodulen (12), bei dem mittels eines Strukturierungswerkzeugs (14) eine Spur in ein Solarmodul eingebracht wird, **dadurch gekennzeichnet, dass** die eingebrachte Spur zeitgleich von einem dem Strukturierungswerkzeug (14) nachlaufenden Sensor (16) erfasst wird.

2. Verfahren nach Anspruch 1, **dadurch gekennzeichnet, dass** die Breite und/oder Tiefe der Spur erfasst wird.

3. Verfahren nach Anspruch 1 oder 2, **dadurch gekennzeichnet, dass** die Positionen einer vorher eingebrachten Spur und die der aktuell eingebrachten Spur erfasst werden.

4. Verfahren nach einem der vorhergehenden Ansprüche, **dadurch gekennzeichnet, dass** zumindest eine die Qualität der Spur beschreibende Größe ermittelt oder erfasst wird und diese Größe mit einer Referenzgröße verglichen wird, wobei bei einem vorgegebenen Vergleichsergebnis eine Qualitätsverbesserungsmaßnahme eingeleitet wird.

5. Verfahren nach einem der vorhergehenden Ansprüche, **dadurch gekennzeichnet, dass** die Solarmodulstrukturierung mittels Laser erfolgt und die Laserleistung und/oder die Fokuslage und/oder das Strahlprofil des Lasers in Abhängigkeit von der erfassten Spurbreite und/oder Spurtiefe eingestellt wird.

6. Verfahren nach einem der vorhergehenden Ansprüche, **dadurch gekennzeichnet, dass** die Solarmodulstrukturierung mittels eines mechanischen Strukturierungswerkzeugs (14), insbesondere eines Stichels, erfolgt und der Anpressdruck des mechanischen Strukturierungswerkzeugs an das Solarmodul (12) in Abhängigkeit von der erfassten Spurbreite und/oder Spurtiefe eingestellt wird.

7. Verfahren nach einem der vorhergehenden Ansprüche, **dadurch gekennzeichnet, dass** die Solarmodulstrukturierung mittels eines mechanischen Strukturierungswerkzeugs (14), insbesondere eines Stichels, erfolgt und ein Nachschärfen des mechanischen Strukturierungswerkzeugs (14) in Abhängigkeit von der erfassten Spurbreite und/oder Spurtiefe durchgeführt wird.

8. Verfahren nach einem der vorhergehenden Ansprüche, **dadurch gekennzeichnet, dass** aufgrund der Sensorsignale auf einen Bruch des Solarmoduls (12) oder einen Kurzschluss zwischen Spuren geschlossen wird.

9. Strukturierungsvorrichtung (10) zur Strukturierung von Solarmodulen (12), mit einem Strukturierungswerkzeug (14), **dadurch gekennzeichnet, dass** ein dem Strukturierungswerkzeug (14) nachlaufender, die mittels des Strukturierungswerkzeugs eingebrachte Spur erfassender Sensor (16) vorgesehen ist.

10. Strukturierungsvorrichtung nach Anspruch 9, **dadurch gekennzeichnet, dass** eine mit dem Sensor (16) datentechnisch in Verbindung stehende Auswerteeinrichtung (17) zur Verarbeitung der Sensorsignale vorgesehen ist.

11. Strukturierungsvorrichtung nach Anspruch 10, **dadurch gekennzeichnet, dass** eine Einstelleinrichtung (18) zur Einstellung des Strukturierungswerkzeugs (14) vorgesehen ist, die durch die Auswerteeinrichtung (17) angesteuert ist.

12. Strukturierungsvorrichtung nach einem der vorhergehenden Ansprüche 9 bis 11, **dadurch gekennzeichnet, dass** der Sensor (16) als optischer Sensor oder als mechanischer Sensor ausgebildet ist.
